(19) **Europäisches Patentamt**

**European Patent Office**

**Office européen des brevets**

(11) **EP 1 504 504 B1**

(12) **EUROPEAN PATENT SPECIFICATION**

(45) Date of publication and mention
of the grant of the patent:
**12.07.2006 Bulletin 2006/28**

(51) Int Cl.:
*H01S 5/0625* (2006.01)   *H01S 5/125* (2006.01)

(21) Application number: **03727672.2**

(22) Date of filing: **15.05.2003**

(86) International application number:
**PCT/GB2003/002108**

(87) International publication number:
**WO 2003/098754 (27.11.2003 Gazette 2003/48)**

(54) **TUNEABLE LASER**

ABSTIMMBARER LASER

LASER ACCORDABLE

(84) Designated Contracting States:
**AT BE BG CH CY CZ DE DK EE ES FI FR GB GR
HU IE IT LI LU MC NL PT RO SE SI SK TR**

(30) Priority: **15.05.2002 GB 0211038
15.05.2002 GB 0211037
15.05.2002 GB 0211039**

(43) Date of publication of application:
**09.02.2005 Bulletin 2005/06**

(73) Proprietor: **BOOKHAM TECHNOLOGY LIMITED
Abingdon,
Oxon OX14 4RY (GB)**

(72) Inventors:
 • **Zakhleniuk, Nickolay
 Colchester,
 Essex CO1 2GX (GB)**
 • **Holden, Anthony, James
 Brackley,
 Northamptonshire NN13 5HX (GB)**

(74) Representative: **Clayton-Hathway, Anthony
Nicholas et al
Fry Heath & Spence LLP
The Gables
Massetts Road
Horley, Surrey RH6 7DQ (GB)**

(56) References cited:
 **EP-A- 0 467 781    EP-A- 1 485 975**

 • **MURATA S ET AL: "SPECTRAL
 CHARACTERISTICS FOR A 1.5 MUM DBR LASER
 WITH FREQUENCY-TUNING REGION" IEEE
 JOURNAL OF QUANTUM ELECTRONICS, IEEE
 INC. NEW YORK, US, vol. QE-23, no. 6, 1 June
 1987 (1987-06-01), pages 835-838, XP000705809
 ISSN: 0018-9197**
 • **KAMP M ET AL: "InGaAs/AlGaAs quantum dot
 DFB lasers operating up to 213 DEG C"
 ELECTRONICS LETTERS, IEE STEVENAGE, GB,
 vol. 35, no. 23, 11 November 1999 (1999-11-11),
 pages 2036-2037, XP006012929 ISSN: 0013-5194**
 • **LESTER L F ET AL: "OPTICAL
 CHARACTERISTICS OF 1.24-MUM INAS
 QUANTUM-DOT LASER DIODES" IEEE
 PHOTONICS TECHNOLOGY LETTERS, IEEE INC.
 NEW YORK, US, vol. 11, no. 8, August 1999
 (1999-08), pages 931-933, XP000860954 ISSN:
 1041-1135**
 • **KIRSTAEDTER N ET AL: "LOW THRESHOLD,
 LARGE TO INJECTION LASER EMISSION FROM
 (INGA)AS QUANTUM DOTS" ELECTRONICS
 LETTERS, IEE STEVENAGE, GB, vol. 30, no. 17,
 18 August 1994 (1994-08-18), pages 1416-1417,
 XP000476036 ISSN: 0013-5194**
 • **HEINRICHSDORFF F ET AL: "ROOM-
 TEMPERATURE CONTINUOUS-WAVE LASING
 FROM STACKED INAS/GAAS QUANTUM DOTS
 GROWN BY METALORGANIC CHEMICAL
 VAPOR DEPOSITION" APPLIED PHYSICS
 LETTERS, AMERICAN INSTITUTE OF PHYSICS.
 NEW YORK, US, vol. 71, no. 1, 7 July 1997
 (1997-07-07), pages 22-24, XP000694849 ISSN:
 0003-6951**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 504 504 B1

- ALLEN C N ET AL: "INAS SELF-ASSEMBLED QUANTUM-DOT LASERS GROWN ON (100) INP" APPLIED PHYSICS LETTERS, AMERICAN INSTITUTE OF PHYSICS. NEW YORK, US, vol. 80, no. 19, 13 May 2002 (2002-05-13), pages 3629-3631, XP001123385 ISSN: 0003-6951

- GRIESINGER U A ET AL: "REALIZATION OF DOT DFB LASERS" IEEE PHOTONICS TECHNOLOGY LETTERS, IEEE INC. NEW YORK, US, vol. 8, no. 5, 1 May 1996 (1996-05-01), pages 587-589, XP000589249 ISSN: 1041-1135

**Description**

This invention relates to tuneable lasers and has particular reference to such tuneable lasers having a tuneable portion incorporating quantum dots.

**Background to the Invention**

In this specification the term "light" will be used in the sense that it is used in optical systems to mean not just visible light but also electromagnetic radiation having a wavelength between 800 nanometres (nm) and 3000 nm.

Single wavelength lasers are important for a number of applications in optical telecommunications and signal processing applications. These include multiple channel optical telecommunications networks using wavelength division multiplexing (WDM). Such networks can provide advanced features, such as wavelength routing, wavelength conversion, adding and dropping of channels and wavelength manipulation in much the same way as in time slot manipulation in time division multiplexed systems. Many of these systems operate in the C- and L- Bands in the range 1530 to 1600 nm.

Tuneable lasers for use in such optical communications systems, particularly in connection with the WDM telecommunication systems, are known. A known tuneable system comprises stacks of single wavelength distributed Bragg reflectors (DBR) lasers, which can be individually selected, or tuned over a narrow range, or by a wide tuning range tuneable laser that can be electronically driven to provide the wavelength required.

In all of these tuneable lasers, reliance is placed on altering the refractive index of the tuning element of the laser by an external action to enable different wavelengths of the laser to be selected to satisfy the necessary lasing conditions. Three main methods of varying the refractive index have been proposed and used. In one method, the free electron plasma effect can be used by free carrier injection, that is by passing an electric current through the tuning section. In such a laser it is not the actual flow of electrons as such through the material which causes the effect, rather it is the variation in the numbers of electrons present in the material which matters. The passage of the current is the way in which additional electrons are injected into the material. Such a laser has therefore to be constructed and adapted in a manner well known per se by having a low resistance so as to permit current to flow through the relevant part of the laser.

In a second method, the fundamental band-gap can be changed by thermal heating. In a third method electro-refraction modification can be brought about using the electro-optic effect. In the latter case, an electrical field is established across the tuning section, which changes the refractive index of the section and thus alters the wavelength of the light as it passes through the tuning section. In such a case the structure of the tuning section is such that it has a high resistance to the passage of an electrical current in response to an applied voltage, so that a field is established rather than significant quantities of current flowing.

Each of the tuning systems has advantages and drawbacks. In particular the thermal tuning scheme is very slow, the current tuning scheme has its speed limited by thermal heating effects and the electro refraction scheme has limited bandwidth of modulation, and large output power variation as a function of wavelength.

Preferably all tuning should be fast, it should consume as little energy as possible and it should provide as broad wavelength tuning as possible, ideally covering the C- and the L-bands, without the output power variation. In the current injection tuning mechanism, the refractive index is modified through the change of the electronic contribution to the dielectric function due to the presence of the electrons in the injection current. At the same time, the injected current creates Joule heating, which dissipates in the device active region. As a result of this, the real wavelength switching speed of the laser device will be determined by the relatively long characteristic time of the heat dissipation, rather than by the electric current switching speed. The thermal dissipation effects can be decreased through device optimisation but cannot be eliminated. The thermally induced band-gap change has similar limitations.

The use of the electro-optic effect relies on the applied voltage rather than injected current and avoids excess heating and long thermal time constants. However, the low refractive index change available in technologically suitable materials, e.g. GaAs and other III-V semiconductors, is the main obstacle to its practical utilisation.

In recent years a great deal of interest has been shown, both theoretically and practically, in quantum well, quantum wire, and quantum dot containing materials. However, there is as yet no universally accepted and adopted nomenclature for these types of materials, for example these types of materials are sometimes referred to as low dimensional carrier confinement materials and other terms are also used. For clarity, therefore, in this specification there will be used three defined terms: quantum wells, which will be referred to as QWs; quantum wires; and quantum dots, which will be referred to as QDs.

In this specification the term QW is used to mean a material having a layer of narrow band-gap material sandwiched between layers of wide band-gap material, with the layer of the narrow band-gap material having a thickness $d_x$ of the order of the de Broglie wavelength $\lambda_{dB}$ and the other two dimensions $d_y$ and $d_z$ of the layer of narrow band-gap material being very much greater than $\lambda_{dB}$. Within such a structure, the electrons are constrained in the x dimension but are free to move in the y and z dimensions. Typically for a III-V As based materials the thickness of the layer for a QW material would be in the range ~50 Å to ~300 Å.

If now the thickness of the layer $d_x$ is reduced to a minimum to give the QW effect, then there is only room in the QW for one energy level for the electrons. An overall QW may have some regions of one energy level only and some regions of a few energy levels.

If the QW is now considered as having a second dimension, say $d_y$, cut down to the size ~$\lambda_{dB}$, so that both $d_x$ and $d_y$ are ~$\lambda_{dB}$ and only $d_z$ is very much greater than $\lambda_{dB}$, then the electrons are constrained in two dimension and thus there is, in effect, created a line in which the electrons can freely move in one dimension only, and this is referred to herein as a quantum wire.

If now the quantum wire is further constrained so that $d_z$ is also ~ $\lambda_{dB}$, then the electrons are constrained within a very small volume and have zero dimension to move in. This is called herein a quantum dot (QD).

Thus if $d_x$, $d_y$, and $d_z$ are all very much greater than $\lambda_{dB}$ the material is simply considered as a bulk material with no quantum effects of the type discussed herein. If $d_x \sim \lambda_{dB}$ there is provided a quantum well, QW. If $d_x$, $d_y \sim \lambda_{dB}$, there is provided a quantum wire, and if $d_x$, $d_y$, and $d_z \sim \lambda_{dB}$, then there is provided a quantum dot, QD.

The technology for producing QWs is well known but quantum wires have yet to be produced on a commercial scale. In practise they have been formed in the laboratory by electrically constraining a QW structure with electrical fields or by so-called V-growth, but these are not yet a practical commercially available processes.

The present invention is concerned with the use and application of QD materials in current injection tuneable lasers. Production processes for QD materials are well established. Two main processes have been developed, chemical etching and self-assembly, and the self-assembly process will be explained in more detail below.

QD materials have been widely suggested for use in lasers, see for example D Bimberg et al, Novel Infrared Quantum Dot Lasers: Theory and Reality, phys. stat. sol. (b) **224**, No. 3, 787-796 (2001). Principally they have been suggested for use in the light creating lasing section of a current injection laser because they can produce light of a very narrowly defined wavelength, with a very low threshold current and QD materials have a very high characteristic temperature so as to give a temperature stable laser emitter. Because of these very significant benefits, most of the work on QD materials in laser applications has concentrated on their use in the emitter.

EP-A-0467 781 discloses a semiconductor optical element (e.g. a tuneable laser) which comprises a semiconductor substrate, a waveguide, an active layer and a clad layer mounted on the substrate. The active layer comprises a first region and a second region coupled optically with each other. Both of the first and second regions produce optical gain and have opposite signs of "alpha" parameters to each other, where said parameter is a ratio of change of refractive index to change of gain following change of carrier density. A first electrode common to all regions is attached on one side of said substrate, and second electrodes for each of the regions are attached on the other side of said substrate.

## Applications of the Invention

The present invention is not directed to the use of QD materials in laser emitters, but is directed to the use of QD materials in the tuning section of a tuneable laser.

QDs are little boxes of narrow band-gap material formed inside the bulk semi-conductor material. They confine the weakly bound electrons and their corresponding holes (in the valence band) and do not allow them to conduct. They are, in essence, artificial atoms.

## Brief Description of the Invention

By the present invention there is provided a tuneable laser including a light creating section to generate light and a tuning section formed of a semiconductor material which utilises the current injection free electron plasma effect to achieve a change in the refractive index of the material, wherein the tuning section incorporates a distributed Bragg reflector and contains a plurality of quantum dots having enhanced polarisability compared to the bulk semiconductor material surrounding the quantum dots, characterised in that the tuning section is not a light creating section and does not generate light.

The tuneable laser may incorporate a phase change section and the phase change section may be a tuneable section.

The semiconductor material may be a III-V semiconductor material, which may be based on a system selected from the group GaAs based, InAs based materials and InP based materials.

The laser may comprise a combination of gain sections, phase sections and tuning sections and thereby be a three or four section laser, or have more than four sections.

The quantum dots are self-assembled quantum dots in which the self-assembled quantum dots may be formed of InAs based material in host GaAs based semiconductor material. The host material may be formed on a GaAs substrate.

The self-assembled quantum dots may be formed of InGaAs based material in host GaAs based semiconductor material which host material may be formed on a GaAs substrate.

The self-assembled quantum dots may be formed of InAs based material in host InGaAsP based semiconductor material which host material may be formed on an InP substrate.

The self-assembled quantum dots may be formed of InGaAs based material in host InGaAsP based semiconductor material which host material may be formed on an InP substrate.

Alternatively, the quantum dots may be formed by a chemical etching process.

There may be a plurality of layers of quantum dots.

A method of operating a tuneable laser as set out above in which the laser has a forward bias with the p-layer of the laser connected positively and the n-layer connected negatively.

## Description of the Preferred Embodiments of the Invention

The present invention will now be described with reference to the accompanying drawings, of which: -

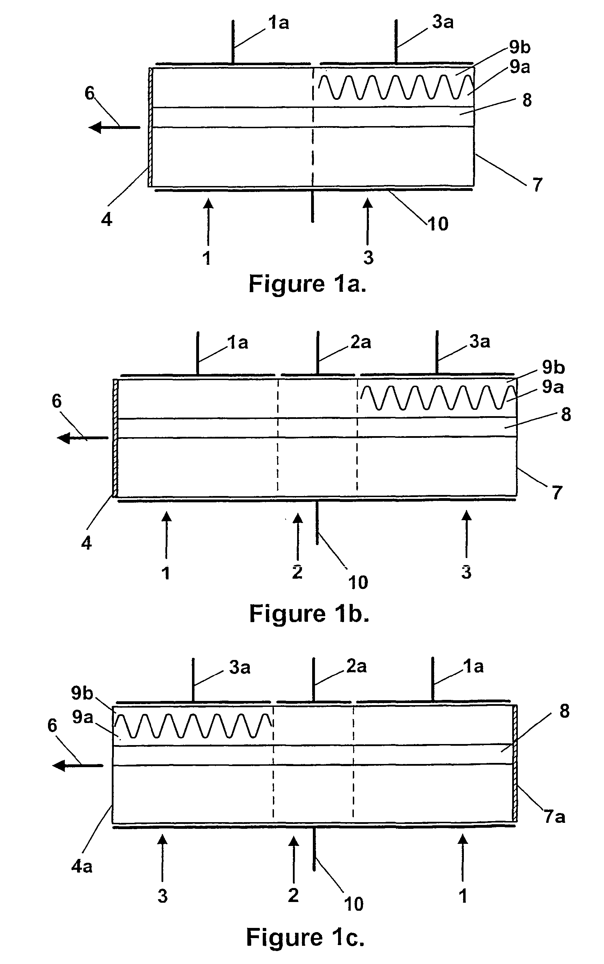

Figure 1a. is a schematic cross section of a two section tuneable laser
Figure 1b. is a schematic cross section of a three section tuneable laser, and
Figure 1c. is a schematic cross section of an alternative three section tuneable laser.

Semiconductor tuneable lasers are known in the art. The principals of tuneable lasers are described in chapters 4 and 5 of "Tuneable Laser Diodes", by Markus-Christian Amann and Jens Bus, ISBN 0-89006-963-8, published by Artech House, Inc.

Referring to Figure 1a., this shows schematically in cross section a first embodiment two-section Distributed Bragg Reflector (DBR) tuneable laser, which can be used to demonstrate how the invention can be put into effect.

The laser comprises a gain section 1, and a tuning section 3 incorporating a DBR grating. At the front of the gain section on the opposite side to the tuning section is a partially reflecting mirror 4, which reflects at all operating wavelengths. The laser works by injecting current through an electrode 1a into the gain section 1 and through a common return electrode 10 to create the carrier population inversion and cause the gain section to emit light. This light is reflected by the tuning section 3, which reflects at the lasing wavelength, and by the mirror 4, so as to build up into laser light at the wavelength of the reflection from the DBR grating, in a manner well known per se. The laser light is emitted from the front of the laser in the direction of the arrow 6. A common optical waveguide 8 formed of a material having a refractive index at zero current of $n_1$ operates across the whole longitudinal lasing cavity of the device. The rear facet 7 of the laser is anti-reflection coated so that it does not produce any secondary reflections, which would disturb the desired operation of the longitudinal lasing cavity formed between the tuning section and the front mirror 4. Typically a tap of laser light from the rear facet 7 may be used in wavelength locker applications.

The tuning section 3 contains a DBR grating formed between a layer of material 9a of a refractive index $n_2$ and an upper layer of material 9b having a refractive index $n_3$ which is lower than the refractive index $n_2$ of the layer 9a. The refractive indices $n_2$ and $n_3$ are both lower than refractive index $n_1$. The DBR grating itself if defined by the boundary between the two layers 9a and 9b. It is formed by laying down layer 9a upon waveguide layer 8, photo etching the layer 9a in the manner well known per se, for example using electron beam writing techniques or phase mask holographic techniques as though it were any other material, and then laying down the upper layer 9b onto the layer 9a which has the DBR grating interface etched into it.

The pitch of the grating formed between layers 9a and 9b can he determined by the Bragg condition

$$\lambda = 2n_{eff}\Lambda \qquad (1)$$

where $\lambda$ is wavelength, $n_{eff}$ is the effective refractive index of the waveguide material. In some cases, see below, $n_{eff}$ may not be exactly the same as $n_1$. A is the pitch for first order gratings, which are preferred as they provide the strongest coupling.

As is well known, if a current is passed via electrode 3a, the effective refractive index of the grating and the active material immediately underneath the electrode is decreased and hence the wavelength of the grating can be current tuned.

The tuneable laser shown in Figure 1a. is in the most basic form. A preferred embodiment is shown in Figure 1b. Common integers have been used for equivalent functionality for all embodiments described.

Figure 1b shows schematically in cross section a three-section DBR tuneable laser. The laser comprises a gain section 1, a phase change section 2 and a tuning section 3. At the front of the gain section on the opposite side to the phase change 2 is a partially reflecting mirror 4, which reflects at all operating wavelengths. The laser works by injecting current through an electrode 1a into the gain section 1 and through the common return electrode 10 to create the carrier population inversion and cause the gain section to emit light. This light is reflected by the tuning section 3, which reflects at the lasing wavelength, and by the partially reflecting mirror 4, so as to build up into laser light at the wavelength of the reflection from the tuning section. The laser light is emitted from the front of the laser in the direction of the arrow 6. The phase matching section 2 is used to maintain a constant longitudinal optical cavity length and thereby prevent mode hoping. The phase section has its own independent electrode 2a. Similarly, the tuning section 3 has its own independent electrode 3a.

Those of ordinary skill will appreciate that the architecture of Figure 1b., may be modified to an alternative preferred embodiment as shown in Figure 1c., wherein the tuning section and gain section have been interchanged. In this architecture the rear facet 7a would be coated for high reflectivity to act as a mirror. In this arrangement the front mirror 4a would be designed for very high transmission and minimal reflectivity so that operationally the cavity defined by 4a and 7a, would be negated by the dynamics of the cavity defined by 7a and the tuning section 3. Each of the sections 1, 2 and 3 in this design has its own independent electrodes 1a, 2a and 3 a respectively.

It will be appreciated that as well as two and three section longitudinal semiconductor tuneable lasers there are other classes of design such as the four-section laser discussed in GB2337135B. In the main these higher order tuneable laser design use alternative mirror arrangements in place of the front facet mirror. In so far as these alternative mirror arrangements rely upon the material refractive index to determine the operating wavelength, so this invention may be used with these higher order tuneable laser designs.

In a similar manner to the electrical drive of the tuning section so the phase section can be electrically driven to make fine-tuning control.

It will be appreciated that, so far, no reference has been made to the tuning section containing QDs.

As mentioned above, QD structures effectively comprise a plurality of small, notionally zero dimension regions, in a host of bulk semiconductor material. These regions are capable of capturing and confining carriers (electrons and/or holes) as described in "Quantum Dot Heterostructures" by D. Bimberg, M. Grundmann and N. N. Ledentsov, published by Wiley, Chichester 1999, chapter 1. The mechanism of the enhanced polarisability of the QDs is described below.

Two main methods of producing QD structures have been developed and are described in chapter 2 of the above reference. The first is to produce a flat relatively thick layer of bulk wide band-gap material and to deposit on it a thin layer of narrow band-gap material each of appropriately chosen lattice constant and band-gap. The thin layer of narrow band-gap material is then covered with a layer of photo-resist, and exposed to form a pattern of dots. The unwanted material is then chemically etched away and the photo-resist is then stripped off. Another thick layer of bulk material is applied and the process is repeated as often as is required.

A preferred alternative method for forming the QDs is however the self-assembly method (SAQDs) as described in chapter 4 the Bimberg, Grundmann and Ledentsov reference above. In this process a thin layer of, for example, InAs is grown rapidly onto a wetting layer on a thick bulk layer of, for example, GaAs. This can be done using either molecular beam epitaxy (MBE) or metal organic vapour phase epitaxy (MOVPE). MOVPE is also sometimes called metal organic chemical vapour deposition (MOCVD).

The amount of the InAs is so controlled as to exceed a critical thickness at which point the grown layer splits into isolated dots as a consequence of the strain between the InAs and the GaAs, of our example, and the growth conditions. These dots can be further overgrown by a further layer of GaAs, and then further InAs dots grown as described. This can be repeated for a plurality of layers. This results in a plurality of layers of individual quantum dots (QD).

MOVPE can be used, as is known, to create QDs on an industrial scale. The QDs are self-assembling and typically contain a few thousand of atoms and are normally very flattened pyramids. The ratio of the pyramid base, $d$, to their height, $h$, is normally in the range of 5 to 100. Since they are self-assembling, the dimensions of each dot cannot be separately controlled however, it is known that the average size and density of dots can be controlled technologically and manufactured reproducibly.

Set out below is how such QDs can be used to enhance the effectiveness of a current injection tuneable laser in accordance with the invention.

In a semiconductor, the core electrons stay on the lattice, whilst the valence electrons go off into the conduction band and become conduction electrons if they attain an energy level sufficient to pass across the band-gap. These electrons are free to move throughout the material and provide electrical conduction.

All current injection tuneable lasers known to date exploit the free electron plasma effect in order to change the refractive index of the material in a tuning section. The effect takes place only if the electron gas has at least one degree of freedom for a free electron motion. In the case of the carriers confined in a quantum dot there is no degree of freedom at all due to complete localisation of the electrons within small volume. As a result there is no plasma effect in quantum dots as opposed to the case of bulk or quantum wells/wires. In consequence it would seem that current injection techniques could not be used to tune lasers which operate on the current injection principle.

However, at the same time, injection of additional electrons into the quantum dots will change the polarisability of the dots and therefore the refractive index of the material incorporating quantum dots. This is a completely novel way of modification of the refractive index of material with quantum dots. The advantage of the invention is that it should provide considerably larger change of the refractive index of the material under the same injection current as compared with present current tuneable lasers. Additionally it is considered possible in principle to combine in a tuneable laser both contributions to the refractive index change due to the plasma effect and due to the incorporation of quantum dots. This is because the fraction of the injected carriers which are not captured (or "fall") into the quantum dots will contribute to the refractive index change through the conventional plasma effect, and the fraction of the captured electrons will change the refractive index due to enhancement of the polarisability of the quantum dots as described above.

If current is injected into a semiconductor material having a refractive index of $n_0$ then the refractive index will change by an amount $\Delta n$ to a new value n, where $n = n_0 + \Delta n$. In the case of current injection with current I, $\Delta n = n_0 [f(I)]$, where f is a complex function. However, in practice, f can be considered to be such a value that $\Delta n$ is approximately directly proportional to I but, additionally, the value of $\Delta n$ is such that $\Delta n$ is very small compared to $n_0$.

Because $\Delta n$ is small compared to no, any changes effected by varying the current injected are also small.

When light is passed through a material it inter-reacts with the atoms forming the material and polarizes the atoms, setting up oscillating waves of background charge - the frequency of such oscillating waves is known as the plasma frequency, $\omega_p$, of the material. $\omega_p^2$ is proportional to $N_e$, where $N_e$ is the electron density within the material. Thus the light responds to the polarization of the atoms, the more electrons the greater the polarization and thus the more electrons the greater the change in the refractive index of the material.

In a QD material the conduction electrons on atoms within a quantum dot cannot get away from the quantum dots, as they cannot attain sufficient energy to overcome the additional confinement energy of the quantum dot. The outer band electrons are confined to the dot and are not free to move through the host semiconductor material and provide electrical conduction. Effectively such QDs behave like large atoms.

When an external current is passed through the structure of a semi-conductor containing QDs, the electrons are captured by the QDs enhancing the inter-reaction between the light, the electric field of the light distorts the atoms and it is this distortion that actually causes linear variation of the refractive index. In a bulk material the light polarises the atoms by interacting with the valence electrons, which are strongly bound to the nucleus of the atoms, so the polarisation is relatively small. However, in a QD where additional electrons are locked into the dot, the QD behaves like a very large artificial atom. The dot is therefore a very highly polarisable artificial atom and $\Delta n$ is increased. Since the polarisability of the artificial atom increases as a function of the number of electrons injected, Ne, the greater the current the more electrons are injected and the greater the effect on $\Delta n$. This unique characteristic of quantum dots (QD) distinguishes them over all other bulk, quantum well or quantum wire semiconductor materials.

An injected current passing through the tuneable section of the laser will exploit the free plasma effect in the bulk (non QD material) in the conventional manner. However, the current will also polarise the QDs and thus increase the variation of the refractive index. Thus two effects will be occurring simultaneously.

Since in absolute terms $\omega_p$ is very small compared to $\omega$, the frequency of the light, and the additional polarisability of the artificial (dot) atoms is small compared to the total polarisability of the solid semiconductor material then $\Delta n$ will be very small compared to $n_0$, thus as $n_{eff} = n_0 + \Delta n$ then $n_{eff}$ will be very close to $n_0$.

This means that although QDs will significantly affect the amount of change in the refractive index of the material containing the QDs, their presence will not significantly affect the absolute value of the refractive index of the material containing the QDs.

It is well known that the bulk of the light passing through the tuneable laser is passing through the waveguide 8. The Bragg grating formed between layers 9a and 9b influences only the evanescent tail of the light passing through the laser. Thus it is possible to influence the light passing through the laser by incorporating QDs in either of the layers 9a or 9b or within the waveguide itself. Whichever layer has the QDs in it will have a significantly greater change of refractive index under the influence of injected current, so that the tuning effect, which relies on the overall change to the effective refractive index $n_{eff}$ of the tuning section as a whole, is significantly increased by the provision of the QDs. For maximum effect the QDs should be located in the region of the material where the optical field is strongest. This would normally be at the high refractive index layer in the waveguide structure.

In addition to the injection of electrons there is a mirror image injection of electron holes into the mirror image of the electron wells that are the QDs.

When a current is passed through the tuneable section, the electrons are initially injected into the bulk material, for example the GaAs material. As a result of the electrons emitting energy by means of non-radiative emission processes, for example by emitting acoustic and/or optical phonons, the energy of the electrons falls. They are very rapidly captured by the quantum dots (on a pico-second time scale). The capture time of the electrons is shorter than the recombination time (see below). The electrons can move into the QDs either directly from the GaAs material or through the wetting layer. The electrons captured initially in the wetting layer continue to lose energy by the processes of emission until they reach the ground state of the dots

The electrons and holes have to recombine to permit the passage of current and the recombination time $\tau_r$ of the holes and the electrons is of the order of $10^{-9}$ to $10^{-12}$ seconds. The value for $\tau_r$ for the QDs is about the same as $\tau_r$

for bulk materials, and as $\tau_r$ is short compared to the frequency at which the laser is retuned there is no problem in using the QDs in a fast reacting tuneable laser.

As set out above, the variation in the refractive index occasioned by an injection of a given amount of current into a QD layer is much greater than in bulk material. For example, in InAs dots in GaAs the enhancement factor has been reported in the literature to be about 200. Even though current technology permits a packing density such that only 3% of the volume of a structure can be formed of QDs, this still means that the overall increase in the polarisability is 3% of 200, i.e. about six times greater. The effect can be further enhanced by incorporating a plurality of quantum dot layers.

This means that compared to bulk material a QD material would be typically six times or more effective in changing the refractive index compared to bulk semiconductor material operating with current injection and not incorporating QDs for the same amount of current passed.

In a practical application with a tuneable semiconductor laser such QD material used in the tuning section would allow the tunability to be increased to typically six times the wavelength range. This makes the invention a viable mechanism for tuning a semiconductor laser.

Use of an InP substrate for deposition of InAs quantum dots has been considered as one of the attractive methods in order to grow quantum dots in the gain or light creating and emitting section of a laser emitting at 1.55 μm, as described by A Pouchet, A Le Corre, H L'Haridon, B Lambert and A. Salaum, Applied Physics Letters No. 67, 1850 (1995).

The current tuneable lasers for 1.55μm are also based on InP/InGaAsP material system. Therefore, it is very important from a practical point of view that quantum dots can also be incorporated into the tuneable section(s) of lasers based on the above materials. Although currently there is no experimental evidence to demonstrate growth of InAs quantum dots on the quarternary materials such as for example, InGaAsP, it is believed that there should not be any technological obstacles to realise such a growth. This is because the most important parameter for quantum dots growth is a lattice mismatch between InAs and InGaAsP. Since the InP layer is lattice matched to InGaAsP, this means that the lattice mismatch between InAs and InGaAsP is the same as between InAs and InP. Consequently, realisation of the quantum dots growth in the latter system means that they should also be capable of being grown in the former material system.

Table 1. below summarises the typical combinations that can be used for dots formed in an epitaxially grown host, which surrounds the quantum dots, on a given substrate.

**Table 1.**

| Dot Material | Host Material | Substrate Material |
|---|---|---|
| InAs | GaAs | GaAs |
| InGaAs | GaAs | GaAs |
| InAs | InGaAsP (Quarternary) | InP |
| InGaAs | InGaAsP (Quarternary) | InP |

Present technology permits the creation of QDs using a wide range of III-V semiconductor materials. This permits the invention to be used in the tuneable section of lasers based on many otherwise unsuitable materials. The number of stacked layers is only limited by the technology available at the time of utilisation of the invention.

The invention thus permits high wavelength tuning speed, a wide tuning range, low energy consumption for switching operation and wavelength holding, and substantial reduction of the Joule heating effect, as compared to conventional current injection lasers.

By including QD material in the tuning section of the laser, and using current to tune it, it is possible to get the required tuning range of at least 40 nm using significantly less injection current than non QD material implementations up to say 6 times less current. The benefit of this effect is that the lower amount of current required means less heating, which in turn means less power consumption but more importantly less heat, so the change in wavelength response time will be much faster. In addition, less current in the tuning section will lead to lower optical loss improving the output power and efficiency of the laser.

Embodiments of tuneable lasers in which QD material is used in the phase sections are possible. In such an embodiment the phase section can be very much shorter, because the refractive index change is much greater, and thus the optical losses through this section can be reduced. Similarly, tuneable laser structures can be envisaged in which the QD material is used for all tuning sections and phase sections such as occur within four section, or higher order, tuneable lasers. QD material may also be used in the gain section of a tuneable laser as is known in the art.

**EP 1 504 504 B1**

**Claims**

1.  A tuneable laser including a light creating section (1) to generate light and a tuning section (3) formed of a semi-conductor material which utilises the current injection free electron plasma effect to achieve a change in the refractive index of the material, wherein the tuning section (3) incorporates a distributed Bragg reflector and contains a plurality of quantum dots having enhanced polarisability compared to the bulk semiconductor material surrounding the quantum dots, **characterised in that** the tuning section (3) is not a light creating section (1) and does not generate light.

2.  A tuneable laser as claimed in claim 1, in which the tuning section (3) comprises a waveguide (8) and the material of the waveguide includes a plurality of quantum dots.

3.  A tuneable laser as claimed in claim 1 or claim 2, in which the distributed Bragg reflector is formed between two layers (9a, 9b) of different refractive indices and a plurality of quantum dots is provided in one of the layers between which the Bragg reflector is formed.

4.  A tuneable laser as claimed in any one of claims 1 to 3, in which the tuneable laser incorporates a phase change section (2) and the phase change section is a tuneable section of the laser.

5.  A tuneable laser as claimed in claim 4, in which the phase change section (2) includes quantum dot material.

6.  A tuneable laser as claimed in any one of claims 1 to 5 in which the semiconductor material is a III-V semiconductor material.

7.  A tuneable laser as claimed in claim 6 in which the III-V semiconductor material is based on a system selected from the group GaAs, InAs based materials and InP based materials.

8.  A tuneable laser as claimed in any one of the preceding claims in which the laser is a three or four section laser, or has more than four sections.

9.  A tuneable laser as claimed in any one of the preceding claims in which the quantum dots are self-assembled quantum dots.

10.  A tuneable laser as claimed in any one of the preceding claims in which the self-assembled quantum dots are formed of InAs based material in host GaAs based semiconductor material.

11.  A tuneable laser as claimed in claim 10 in which the host material is formed on a GaAs substrate.

12.  A tuneable laser as claimed in any one of claims 1 to 9 in which the self-assembled quantum dots are formed of InGaAs based material in host GaAs based semiconductor material.

13.  A tuneable laser as claimed in claim 12 in which the host material is formed on a GaAs substrate.

14.  A tuneable laser as claimed in any one of claims 1 to 9 in which the self-assembled quantum dots are formed of InAs based material in host InGaAsP based semiconductor material.

15.  A tuneable laser as claimed in claim 14 in which the host material is formed on an InP substrate.

16.  A tuneable laser as claimed in any one of claims 1 to 9 in which the self-assembled quantum dots are formed of InGaAs based material in host InGaAsP based semiconductor material.

17.  A tuneable laser as claimed in claim 16 in which the host material is formed on an InP substrate.

18.  A tuneable laser as claimed in any one of claims 1 to 8 in which the quantum dots are formed by a chemical etching process.

19.  A tuneable laser as claimed in any one of claims 1 to 18 in which there is a plurality of layers of quantum dots.

20.  A method of operating a tuneable laser as claimed in any one of claims 1 to 19 in which the laser has a forward bias with the p-layer of the laser connected positively and the n-layer connected negatively.

**Patentansprüche**

1. Abstimmbarer Laser mit einem Lichterzeugungsteil (1) zum Erzeugen von Licht und einem Abstimmteil (3) aus einem Halbleitermaterial, der den strominjektionsfreien Elektronenplasmaeffekt nutzt, um eine Änderung des Brechungsindexes des Materials zu erzielen, wobei der Abstimmteil (3) einen verteilten Bragg-Reflektor beinhaltet und eine Mehrzahl von Quantenpunkten mit erhöhter Polarisierbarkeit im Vergleich zu dem die Quantenpunkte umgebenden Volumenhalbleitermaterial enthält, **dadurch gekennzeichnet, dass** der Abstimmteil (3) kein Lichterzeugungsteil (1) ist und kein Licht erzeugt.

2. Abstimmbarer Laser nach Anspruch 1, bei dem der Abstimmteil (3) einen Wellenleiter (8) umfasst und das Material des Wellenleiters eine Mehrzahl von Quantenpunkten beinhaltet.

3. Abstimmbarer Laser nach Anspruch 1 oder Anspruch 2, bei dem der verteilte Bragg-Reflektor zwischen zwei Schichten (9a, 9b) mit unterschiedlichen Brechungsindexen gebildet ist und eine Mehrzahl von Quantenpunkten in einer der Schichten vorgesehen ist, zwischen denen der Bragg-Reflektor ausgebildet ist.

4. Abstimmbarer Laser nach einem der Ansprüche 1 bis 3, wobei der abstimmbare Laser einen Phasenänderungsteil (2) beinhaltet und der Phasenänderungsteil ein abstimmbarer Teil des Lasers ist.

5. Abstimmbarer Laser nach Anspruch 4, bei dem der Phasenänderungsteil (2) Quantenpunktmaterial beinhaltet.

6. Abstimmbarer Laser nach einem der Ansprüche 1 bis 5, bei dem das Halbleitermaterial ein III-V Halbleitermaterial ist.

7. Abstimmbarer Laser nach Anspruch 6, bei dem das III-V Halbleitermaterial auf einem System basiert, das ausgewählt ist aus der Gruppe von Materialien auf der Basis von GaAs, InAs und von Materialien auf der Basis von InP.

8. Abstimmbarer Laser nach einem der vorherigen Ansprüche, wobei der Laser ein Laser mit drei oder vier Sektionen ist oder mehr als vier Sektionen hat.

9. Abstimmbarer Laser nach einem der vorherigen Ansprüche, bei dem die Quantenpunkte selbstorganisierte Quantenpunkte sind.

10. Abstimmbarer Laser nach einem der vorherigen Ansprüche, bei dem die selbstorganisierten Quantenpunkte aus einem Material auf InAs-Basis in einem Wirtshalbleitermaterial auf GaAs-Basis ausgebildet sind.

11. Abstimmbarer Laser nach Anspruch 10, bei dem das Wirtsmaterial auf einem GaAs-Substrat ausgebildet ist.

12. Abstimmbarer Laser nach einem der Ansprüche 1 bis 9, bei dem die selbstorganisierten Quantenpunkte aus einem Material auf InGaAs-Basis auf einem Wirtshalbleitermaterial auf GaAs-Basis ausgebildet sind.

13. Abstimmbarer Laser nach Anspruch 12, bei dem das Wirtsmaterial auf einem GaAs-Substrat ausgebildet ist.

14. Abstimmbarer Laser nach einem der Ansprüche 1 bis 9, bei dem die selbstorganisierten Quantenpunkte aus einem Material auf InAs-Basis in einem Wirtshalbleitermaterial auf InGaAsP-Basis ausgebildet sind.

15. Abstimmbarer Laser nach Anspruch 14, bei dem das Wirtsmaterial auf einem InP-Substrat ausgebildet ist.

16. Abstimmbarer Laser nach einem der Ansprüche 1 bis 9, bei dem die selbstorganisierten Quantenpunkte auf einem Material auf InGaAs-Basis in einem Wirtshalbleitermaterial auf InGaAsP-Basis ausgebildet sind.

17. Abstimmbarer Laser nach Anspruch 16, bei dem das Wirtsmaterial auf einem InP-Substrat ausgebildet ist.

18. Abstimmbarer Laser nach einem der Ansprüche 1 bis 8, bei dem die Quantenpunkte mit einem chemischen Ätzprozess ausgebildet werden.

**19.** Abstimmbarer Laser nach einem der Ansprüche 1 bis 18, bei dem eine Mehrzahl von Quantenpunktschichten vorhanden ist.

**20.** Verfahren zum Betreiben eines abstimmbaren Lasers nach einem der Ansprüche 1 bis 19, bei dem der Laser eine Durchlassvorspannung hat, wobei die p-Schicht des Lasers positiv und die n-Schicht negativ geschaltet sind.


**Revendications**

**1.** Laser accordable comprenant une partie de création de lumière (1) pour produire une lumière et une partie d'accord (3) constituée d'un matériau semi-conducteur qui utilise l'effet de plasma des électrons sans l'injection de courant pour procurer un changement d'indice de réfraction du matériau, dans lequel la partie d'accord (3) comporte un réflecteur de Bragg réparti et contient une pluralité de points quantiques ayant une polarisabilité accrue comparée au matériau semi-conducteur de masse entourant les points quantiques, **caractérisé en ce que** la partie d'accord (3) n'est pas une partie de création de lumière (1) et ne produit pas de lumière.

**2.** Laser accordable selon la revendication 1, dans lequel la partie d'accord (3) comprend un guide d'onde (8) et le matériau du guide d'onde comprend une pluralité de points quantiques.

**3.** Laser accordable selon la revendication 1 ou la revendication 2, dans lequel le réflecteur de Bragg réparti est formé entre deux couches (9a, 9b) d'indices de réfraction différents et une pluralité de points quantiques est prévue dans l'une des couches entre lesquelles est formé le réflecteur de Bragg.

**4.** Laser accordable selon l'une quelconque des revendications 1 à 3, dans lequel le laser accordable comporte une partie de changement de phase (2) et la partie de changement de phase est une partie accordable du laser.

**5.** Laser accordable selon la revendication 4, dans lequel la partie de changement de phase (2) comprend un matériau à points quantiques.

**6.** Laser accordable selon l'une quelconque des revendications 1 à 5, dans lequel le matériau semi-conducteur est un matériau semi-conducteur III-V.

**7.** Laser accordable selon la revendication 6, dans lequel le matériau semi-conducteur III-V est basé sur un système sélectionné dans les matériaux du groupe à base de GaAs, InAs et les matériaux à base de InP.

**8.** Laser accordable selon l'une quelconque des revendications précédentes, dans lequel le laser est un laser en trois ou quatre parties, ou possède plus de quatre parties.

**9.** Laser accordable selon l'une quelconque des revendications précédentes, dans lequel les points quantiques sont des points quantiques auto-assemblés.

**10.** Laser accordable selon l'une quelconque des revendications précédentes, dans lequel les points quantiques auto-assemblés sont formés de matériau à base de InAs dans un matériau hôte semi-conducteur à base de GaAs.

**11.** Laser accordable selon la revendication 10, dans lequel le matériau hôte est formé sur un substrat de GaAs.

**12.** Laser accordable selon l'une quelconque des revendications 1 à 9, dans lequel les points quantiques auto-assemblés sont formés de matériau à base de InGaAs dans un matériau hôte semi-conducteur à base de GaAs.

**13.** Laser accordable selon la revendication 12, dans lequel le matériau hôte est formé sur un substrat de GaAs.

**14.** Laser accordable selon l'une quelconque des revendications 1 à 9, dans lequel les points quantiques auto-assemblés sont formés de matériau à base de InAs dans un matériau hôte semi-conducteur à base de InGaAsP.

**15.** Laser accordable selon la revendication 14, dans lequel le matériau hôte est formé sur un substrat de InP.

**16.** Laser accordable selon l'une quelconque des revendications 1 à 9, dans lequel les points quantiques auto-assemblés sont constitués d'un matériau à base de InGaAs dans un matériau hôte semi-conducteur à base de InGaAsP.

**17.** Laser accordable selon la revendication 16, dans lequel le matériau hôte est formé sur un substrat de InP.

**18.** Laser accordable selon l'une quelconque des revendications 1 à 8, dans lequel les points quantiques sont formés par un procédé de gravure chimique.

**19.** Laser accordable selon l'une quelconque des revendications 1 à 18, dans lequel il y a une pluralité de couches de points quantiques.

**20.** Procédé d'exploitation d'un laser accordable selon l'une quelconque des revendications 1 à 19, dans lequel le laser a une polarisation directe, la couche P du laser étant connectée positivement et la couche N connectée négativement.

**Figure 1a.**

**Figure 1b.**

**Figure 1c.**